Europäisches Patentamt

European Patent Office

Office européen des brevets

(11) Publication number: **0 377 084 B1**

# EUROPEAN PATENT SPECIFICATION

(45) Date of publication of patent specification: **22.06.94**

(51) Int. Cl.5: **H01L 29/784**, H01L 29/10, H01L 21/84

(21) Application number: **89118307.1**

(22) Date of filing: **03.10.89**

(54) **Field effect transistor on an insulator and method of manufacturing same.**

(30) Priority: **03.10.88 JP 249382/88**
**14.02.89 JP 34406/89**
**21.04.89 JP 100310/89**

(43) Date of publication of application:
**11.07.90 Bulletin 90/28**

(45) Publication of the grant of the patent:
**22.06.94 Bulletin 94/25**

(84) Designated Contracting States:
**DE FR**

(56) References cited:
**EP-A- 0 129 037**
**GB-A- 2 118 365**

**JAPANESE JOURNAL OF APPLIED PHYSICS;
SUPPLEMENTS, 20th - 22nd August 1986,
pages 81-84, Tokyo, JP; T. UEDA et al.: "Electrical characteristics of submicron poly si
MOSFET"**

**I.E.E.E. ELECTRON DEVICE LETTERS, vol.
EDL-7, no. 4, April 1986, pages 244-246, IEEE,
New York, NY, US; J.-P. COLINGE: "Subthreshold slope of thin-film SOI MOSFET's"**

(73) Proprietor: **KABUSHIKI KAISHA TOSHIBA
72, Horikawa-cho
Saiwai-ku
Kawasaki-shi Kanagawa-ken 210(JP)**

(72) Inventor: **Takahashi, Minoru
Toshibaisogo-dairyo
2-9-3 Shiomidai
Isogo-ku Yokohama-shi Kanagawa-ken(JP)**
Inventor: **Yoshimi, Makoto
1-24-1 Shinmachi
Setagaya-ku Tokyo(JP)**
Inventor: **Shigyo, Naoyuki
Haitsushibamoto B-203
4-18-5 Seya
Seya-ku
Yokohama-shi Kanagawa-ken(JP)**

(74) Representative: **Lehn, Werner, Dipl.-Ing. et al
Hoffmann, Eitle & Partner,
Patentanwälte,
Postfach 81 04 20
D-81904 München (DE)**

I.E.E.E. TRANSACTIONS ON ELECTRON DE-
VICES, vol. ED-34, no. 10, October 1987,
pages 2173-2177, IEEE, New York, NY, US;
J.-P. COLINGE: "Hot-electron effects in sili-
con-on-insulator n-channel MOSFET's"

## Description

BACKGROUND OF THE INVENTION

Field of the invention

This invention relates to a semiconductor device having a MOS transistor formed on an insulating film thereof, and particularly to a semiconductor device improved in transistor characteristics.

Description of the Prior Art

A MOS transistor formed on an SOI film is a hopeful device in that it has advantageous merits, such as latchup free, low parasitic capacitance and the like. Particularly, as reported in the article "NOVEL SOI CMOS DESIGN USING ULTRA THIN NEAR INTRINSIC SUBSTRATE" in Tech. Abs. of IEDM, 1982, pp.107-110, when the SOI film is so thinned that the channel region is completely depleted in the operative mode, the punchthrough resistance can be improved, further performances for reduction of the punchthrough effect and the like can be improved.

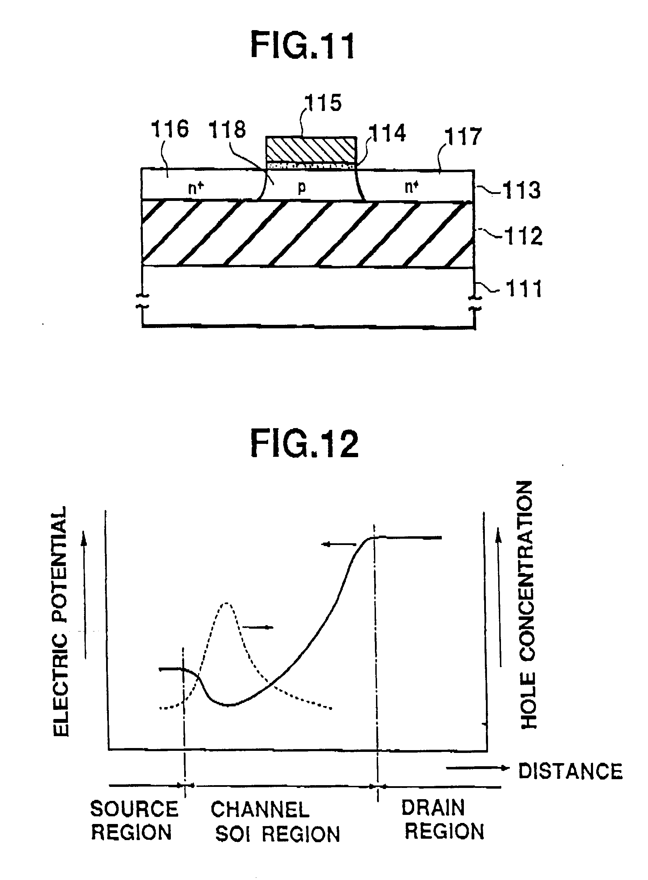

Fig. 11 is a cross sectional view to show element construction of a semiconductor device of this sort. In the drawing, there are shown a silicon substrate 111, an insulating film 112, an SOI film 113, a gate oxide film 114, a gate electrode 115, a source and a drain region 116, 117, and a channel region 118. Herein the thickness of the SOI film 113 is adjusted to be a several hundred angstromes so that the channel region is completely depleted in the operative mode of the device.

With respect to the above conventional device, the following fact could be clearly confirmed by simulations and detailed measurements of the transistor characteristics thereof. Namely, when the device feature size becomes small, the so-called drain breakdown, on which the drain current rapidly increases with the drain voltage, becomes likely to be caused. Accordingly, it is clearly recognized that a range of voltage of the power source usable in this case should be strictly limited. As is shown in Fig, 12, the cause of the above phenomenon is that a low potential region is formed at the boundary between the source region 116 and channel SOI region 118, then holes (designated by a dot line in the drawing) generated by an impact-on phenomenon in the vicinity of the drain region 117 are accumulated in the low potential region.

Namely, when the holes are accumulated between the source and the channel SOI, an energy barrier between the source and the channel SOI is lowered, and a current flows in excess, so that the drain breakdown is caused.

While, when the SOI film is thinned, the following problem is caused in addition to the above problem. Namely, when the SOI film is thinned, the thickness of the source and the drain diffusion region becomes necessarily thinned. Accordingly, the resistance in the diffusion regions is increased and reduction of the current amplification factor is caused. Moreover, when the thin diffusion region is opened to form contact holes by the dry etching method, the diffusion region may be removed, thus the electric wiring to be conducted thereafter may become impossible.

As stated above, according to the conventional element construction based on a thinned SOI film, it is difficult to obtain satisfactory ability of a MOS transistor.

EP-A-0 129 037 describes a polysilicon FET in which the polysilicon channel layer must be thin enough that it is completely depleted. In the article in the Japanese Journal of Applied Physics; Supplements, 20-22, August 1986, pp 81-84, entitled "Electrical Characteristics of Sub-micron Poly-Si MOSFET" by Tohru Ueda and Hiroski Shimizu, the polysilicon thickness is chosen much thinner than the maximum depletion layer width resulting in full channel depletion. In the article in IEEE Electron Device Letters EDL-7 (1986) April No. 4, pp 244-246, entitled "Subthreshold slope of Thin-film SOI MOSFETS by J-P Colinge, silicon-on-insulator n-channel transistors are described in which the silicon film thickness is smaller than the maximum depletion depth.

In the article in IEEE Electron Device Letters, ED-34 (1987) October No. 10, entitled "Hot Electron Effects in silicon-On-Insulator n-channel MOSFETS" the use of fully depleted films in SOI MOSFETS enhances drain-saturation voltages and reduces drain electric fields.

GB-A-2 118 365 describes a thin-film MOS transistor in which the drain and source regions are thicker than the channel region.

SUMMARY OF THE INVENTION

An object of the present invention is to provide a semiconductor device which enables improvement the drain breakdown voltage of MOS transistors formed on SOI films and is able to be operated at a high speed, and manufacturing method thereof.

In order to achieve the object, a thin film transistor semiconductor device according to the present invention is provided, comprising:

a source region and a drain region, each comprising a high-concentration-impurity-diffusion region and provided at a predetermined interval formed on an insulating film;

a gate electrode formed on a channel region interposed between said source region and drain region through a gate insulating film;

a thickness of said channel region being so adjusted as to be smaller than a maximum distance allowable to complete depletion of said channel region and the source region and the drain region have a higher impurity concentration that the channel region,

characterized in that

the thickness of the channel region is smaller than the thickness of said source region and said drain region, and a region having a width less than the maximum depletion distance and an impurity concentration substantially the same or larger than that of said channel region and less than that of said drain region is provided between said channel region and said drain region and the region has substantially the same thickness as the drain region.

The semiconductor device comprises a pair of high-concentration-impurity diffusion regions (16,17) (source and drain regions) formed so as to define a predetermined interval therebetween in a semiconductor layer (13) formed on an insulating film, (12) and a gate electrode (15) formed on a channel region (18) interposed between the diffusion regions (16, 17) through a gate insulating film (14);

and respective conductive types of the diffusion regions and the channel regions are arranged to be the same;

further when the thickness of the semiconductor layer is designated as T, impurity concentration of the semiconductor layer as Nsub (cm$^{-3}$), dielectric constant as, Fermi energy as $\phi$F (eV), and basic electric charge of an electron as q (coulomb), the following equation is estabished:

$$T < 2 \{ F/(qNsub)\}H1/2.$$

The thickness (T$_1$) of a semiconductor layer in a channel region (48) is arranged to be less than a maximum distance allowable to complete depletion (maximum depletion distance) in the channel region (48), and the thicknesses of the semiconductor layer in the diffusion regions (46, 47) are arranged to be thicker than that of the channel region (48). When a semiconductor device is formed as stated above, since the conductive type of the channel region between the source and the drain region is the same as those of the source and the drain region, the energy barrier between the source region and the channel SOI region is lowered in the operative mode, and the drain breakdown voltage can be elevated, Incidentally, though the conductive type of the channel SOI region is the same as those of the source and the drain region, the drain current can be controlled low at OV of the gate voltage.

Moreover, since a sufficiently thin single-crystal semiconductor layer can be obtained in the channel region, there can be obtained a transistor excellent in the switching characteristic. Additionally, since the thickness of the single-crystal semiconductor layer can be increased in the source and the drain region, the increase of the resistance in the diffusion regions cased by thinning the SOI film, which is one of the above problems, is mitigated, and it becomes possible to prevent the disappearance of the diffusion regions which may be conventionally caused on forming of the contact holes.

These and other objects, features and advantages of the present invention will be more apparent from the following description preferred embodiments, taken in conjunction with the accompanying drawings.

## BRIEF DESCRIPTION OF THE DRAWINGS

Fig. 1 is a cross sectional view to show an MOS transistor;

Fig. 2 (a) to 2 (d) are diagrams to show a manufacturing procedure of the MOS transistor shown in Fig. 1;

Fig. 3 is a diagram to show Drain Current-Drain Voltage characteristic curves of the MOS transistor shown in Fig. 1 and the MOS transistor described as a conventional example;

Fig. 4 is a cross sectional view to show a further MOS transistor;

Fig. 5(a) to 5(e) are diagrams to show a manufacturing procedure of the MOS transistor shown in Fig. 4;

Fig. 6 is a cross sectional view to show a yet another MOS transistor;

Fig. 7(a) to 7(d) are diagrams to show a manufacturing procedure of the MOS transistor shown in Fig. 6;

Fig. 8 is a cross sectional view to show a modified example of concave portions in insulating films in the above MOS transistors;

Fig. 9 is a cross sectional view to show an MOS transistor of a first embodiment of the present invention;

Fig. 10(a) to 10(g) are diagrams to show a manufacturing procedure of the MOS transistor shown in Fig. 9;

Fig. 11 is a cross sectional view of a conventional MOS transistor; and

Fig. 12 is a diagram to show relation between electric potential and concentration of holes in an SOI portion of the MOS transistor shown in Fig. 11.

DETAILED DESCRIPTION OF THE EMBODIMENT

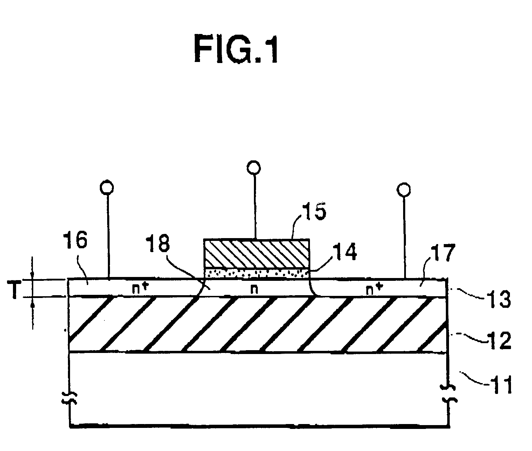

Fig. 1 is a cross sectional view to show schematical construction of a semiconductor device.

In the drawing, reference numeral 11 designates a silicon substrate, on which is formed an n-type single-crystal silicon layer (SOI film) 13 through an $SiO_2$ film (insulating film) 12. On the silicon layer 13, a gate electrode 15 is formed through a gate oxide film 14, further on the silicon layer 13, $n^+$-type impurity diffusion layers (source region and drain region) 16 and 17 are formed. Between the source region 16 and the drain region 17, a channel region 18 is interposed under the gate electrode 15. These source and drain regions 16, 17 and channel region 18 are of the same conductive type. The thickness of the silicon layer 13 is, for example, 700Å, this thickness (T) is thinner than the thickness of the channel 18 to be completely depleted in the operative mode of the element. Namely, the thickness satisfies the condition based on the following equation:

$$T \leqq 2\,[\epsilon\phi F/(qNsub)]^{1/2}$$

where Nsub is impurity concentration of the silicon layer 13 ($cm^{-3}$), $\epsilon$ is dielectric constant, $\phi F$ is Fermi energy (eV), and q is basic electric charge of an electron (coulomb).

Next, a manufacturing method of the above MOS transistor will be explained.

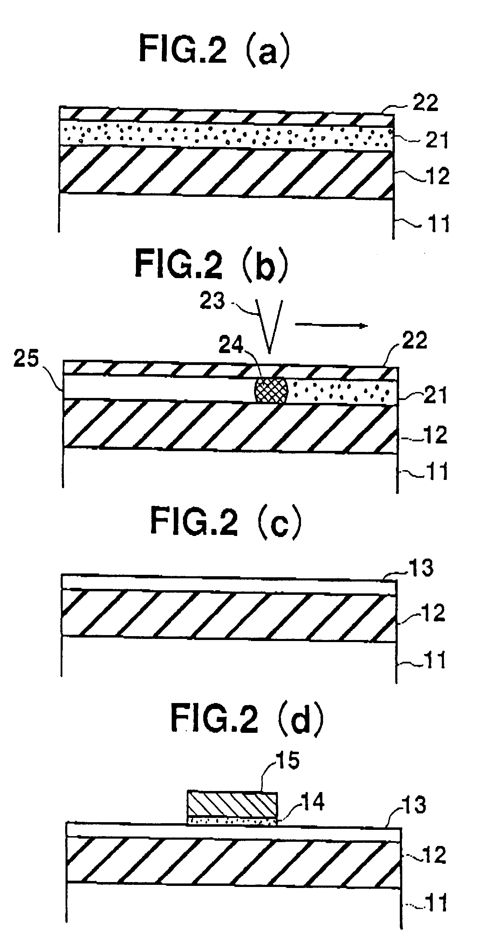

Figs. 2(a) to 2(d) are cross sectional views to show a manufacturing procedure of the MOS transistor.

First, as shown in Fig. 2(a), on the single-crystal silicon substrate 11 having a surface with (100) orientation, the $SiO_2$ layer 12 (insulating film) with a thickness of 1 $\mu$m and a polycrystalline silicon film 21 with a thickness of 800 nm (8000Å) were deposited by LPCVD (Low Pressure Chemical Vapor Deposition) method. Then, on the silicon film 21, an $SiO_2$ film (protective layer) 22 with thickness of 300 nm (3000Å) was deposited.

Subsequently, as shown in Fig. 2(b), the polycrystalline silicon film 21 was melted and recrystallized by scanning of an electron beam 23. Herein, reference numerals 24, 25 designate a melted portion and a single-crystal portion respectively. Thereafter, the silicon film 25 in the single-crystal state was etched over all by a dry etching method till the thickness thereof became 70 nm (700 Å). Then, As (arsenic) ions were doped into the silicon film 25 under the condition of the acceleration voltage of 40KeV and the dose amount of 1 x $10^{11}$ $cm^{-2}$.

As the result, as shown in Fig. 2(c), the n-type single-crystal silicon layer 13 with a sufficiently thin thickness could be obtained.

Incidentally, the doping of ions of impurity may be conducted to the polycrystalline silicon film 21 before the above single-crystallization by the electron beam (23).

Next, as shown in Fig. 2(d), on the silicon layer 13, the gate electrode 15 was formed with a polycrystalline silicon doped with boron ions through the gate oxide film 14. Then, the $n^+$-type diffusion layers (source region and drain region) 16, 17 were formed by As ion doping into the silicon layer 13 under the condition of the acceleration voltage 40KeV and the dose amount of 2 x $10^{15}$ $cm^{-2}$ using the gate electrode 15 as a mask. As stated above, the manufacturing of the MOS transistor was completed. In the so-obtained MOS transistor, the thickness of the SOI film was 50 nm (500 Å) and the concentration of As in the channel region 18 was 2 x $10^{16}$ $cm^{-3}$.

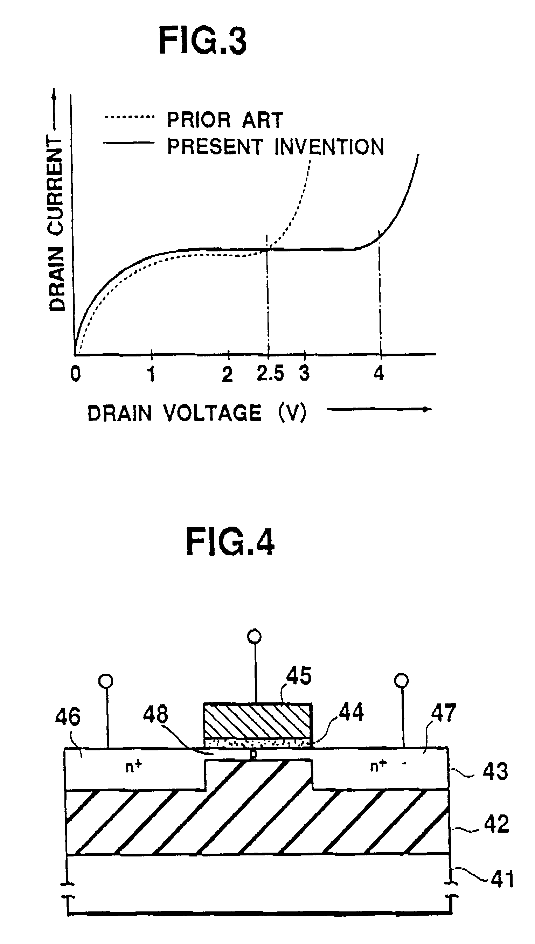

Fig. 3 shows a result of comparison of the drain current-drain voltage characteristic of the MOS transistor element and the above conventional element. As shown in the drawing, when the element in an n channel element in which the length of the channel region is 0.5 $\mu$m the drain break voltage is improved from 2.5V to 4V. According to the result of simulation by a computer, it could be clearly understood that the energy barrier between the source region and the channel SOI region is lowered in the operative rode of the element because the same n-type impurity is doped in the channel region, and the source and the drain region. Thus, the phenomenon as shown in Fig.3 is caused. Moreover, even though the channel region, and the source and the drain region are of the same conductive type (n), the drain current at a gate voltage of OV is controlled to be sufficiently small. The reason is that the SOI film is completely depleated at the gate voltage of OV because the thickness thereof is very thin 50 on (500 Å), so that the electric potential of the channel SOI region to electrons becomes to high as to cut off the passage of a flow of electrons.

Fig. 4 is a cross sectional view to show schematical construction of a further semiconductor device.

In the drawing, reference numeral 41 designates a single-crystal silicon substrate on which is formed a p-type single-crystal silicon layer (SOI film) 43 through an $SiO_2$ film (insulating film) 42 partly having a convex portion. On the silicon layer 43, a gate electrode 45 is formed through a gate oxide film 44 on the convex portion of the $SiO_2$ film 42, further on the silicon layer 43, $n^+$-type impurity diffusion layers (source region and drain region) 46 and 47 are so formed as to interpose a channel region 48 located under the gate electrode 45.

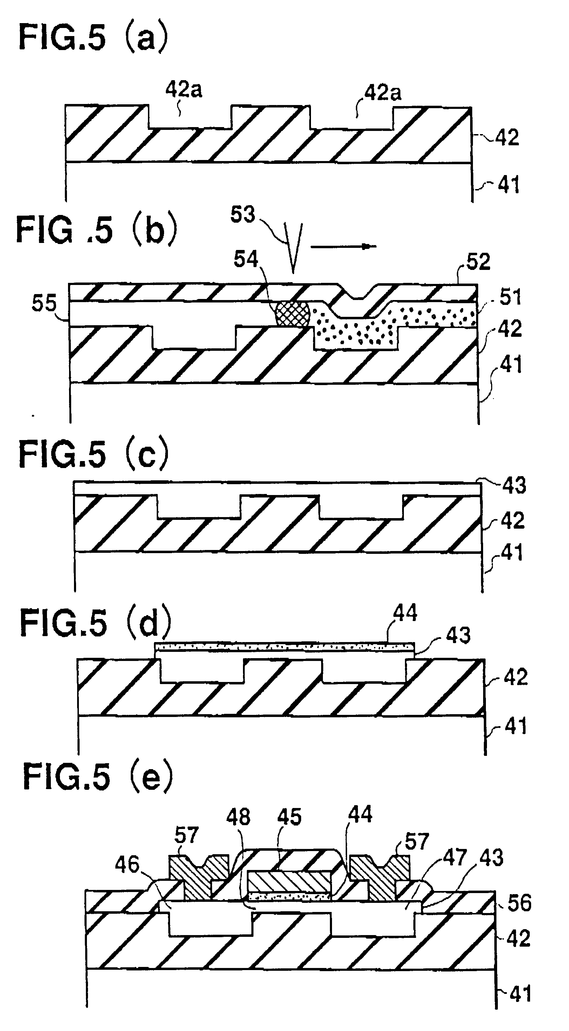

Fig. 5(a) to 5(e) show a manufacturing procedure of the above MOS transistor.

First, as shown in Fig. 5(a), the $SiO_2$ film 42 (insulating film) with a thickness of 1.5 $\mu$m was deposited by the CVD method on the single-crystal silicon substrate 41 having a surface with (100) orientation. Then, a resist pattern (not shown) was formed on the $SiO_2$ film 42, and concaved portions 42a with a depth of 500 nm (5000Å) were formed at a predetermined interval in the $SiO_2$ film 42 by the reactive ion etching (RIE) method. Thereafter, the resist pattern which was used as a mask was removed.

Subsequently, as shown in Fig. 5(b), a polycrystalline silicon film 51 with a thickness of 1.5 $\mu$m was deposited on the $SiO_2$ film over all, further an $SiO_2$ film 52 (protective film) with a thickness of 500 nm (5000Å) was deposited thereon by the CVD method. Then, the polycrystalline silicon film 51 was melted and recrystallized by scanning of an electron beam 53. Herein, the acceleration voltage of the electron beam was 12KeV, and the beam current was 6mA. Incidentally, reference numerals 54 and 55 designate a melt portion and a single-crystal portion formed by the melting recrystallization by the beam annealing.

Then, the $SiO_2$ film 52 was removed with an ammonium fluoride solution to obtain a single-silicon film 55 having thick portions on the concave portions of the $SiO_2$ layer 42 and thin portions on convex portions thereof. Subsequently, the surface of the single-crystal silicon film 55 was oxidized by the hydrogen combustion oxidization at 1000°C to form an oxide film (not shown). Thereafter, the oxide film was removed with an ammonium fluoride solution to form a p-type single-crystal silicon layer 43 with a thin thickness as shown in Fig. 5(c). At the time, the thickness of a portion to be the channel region 48 in Fig. 4 in the single-crystal silicon layer 43 on the convex portion in the $siO_2$ film 42 was arranged to be 1000Å. While, the thickness of portions in the single-crystal silicon layer 43 to be the source and the drain region on the concave portions in the $SiO_2$ film was arranged to be 600 nm (6000Å).

Next, as shown in Fig. 5(d), a resist pattern (not shown) was formed on the single-crystal silicon layer 43, and the single-crystal layer 43 out of element regions was removed by the RIE method using the resist pattern as a mask. Moreover heat oxidization was conducted under the condition of 900°C to form $SiO_2$ film 44 (gate oxide film) with a thickness of 20 nm (200 Å)

Then, as shown in Fig. 5(e), in accordance with a usual preparation procedure of a MOS transistor, the gate electrode 45 was formed, thereafter the n⁺-type diffusion regions (source region and drain region) 46, 47 were formed, and an insulating film 56 was formed over all the resultant surface, further contact holes were formed in the surface by the dry etching method. Lastly, aluminium wires were provided thereon, and then the manufacturing of this MOS transistor was completed.

In the so-obtained MOS transistor, the thickness of the semiconductor layer in the channel region 48 is extremely small 90 nm (900Å), thus the transistor is excellent in the switching characteristic. While, the thickness of the semiconductor layer 43 in the source and the drain region 46m 47 is large 590 nm (5900Å), thus the increase of resistance in the diffusion regions caused by a relatively thin SOI film can be prevented, and the disappearance of the diffusion regions which is the problem conventionally caused on forming the contact holes can be also prevented.

Thus, the maximum potential ability of the thin film transistor can be presented.

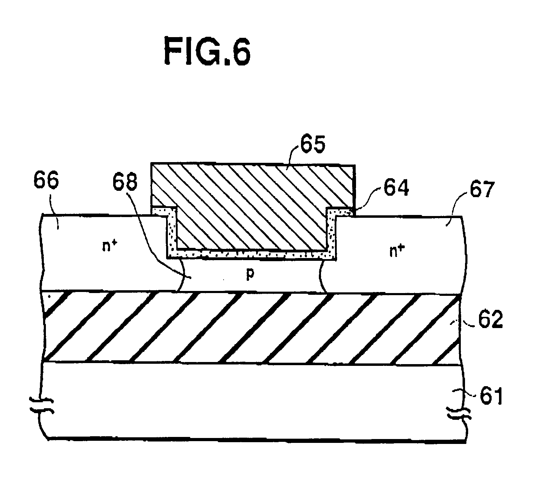

Fig. 6 is a cross sectional view to show schematical construction of a yet another semiconductor device.

In the drawing, reference numeral 61 is designates a single-crystal silicon substrate on which is formed a p-type single-crystal silicon layer (SOI film) 63 through an $SiO_2$ film (insulating film) 62. In the surface of the silicon layer 63, a concave portion is provided in a portion corresponding to a channel region 68. On the concave portion, a gate electrode 65 is formed through a gate oxide film 64. Further, on the silicon layer 63, impurity diffusion layers (source region and drain region) 66, 67 are so formed as to interpose the channel region 68 under the gate electrode 65.

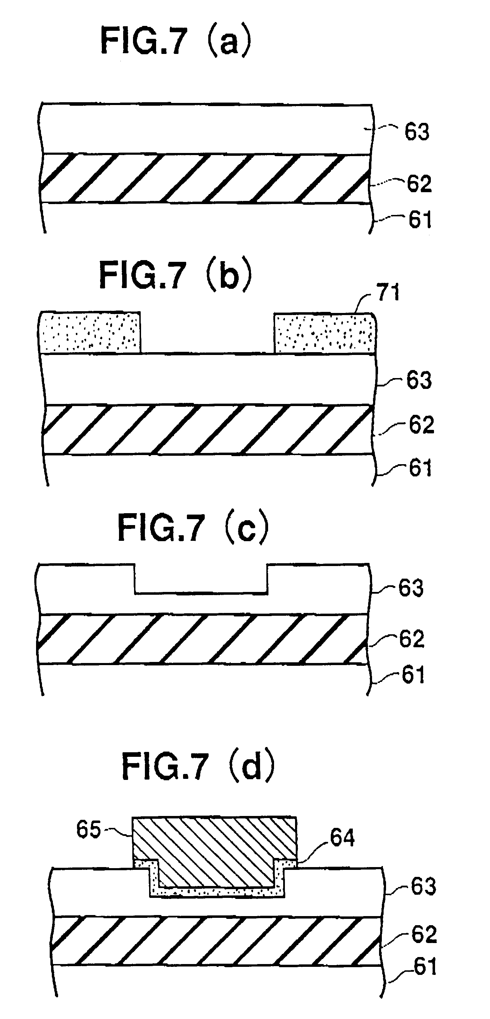

Figs. 7(a) to 7(d) are cross sectional views to show a manufacturing procedure of the above MOS transistor.

First, as shown in Fig. 7(a), the p-type silicon substrate 61 was prepared, and the substrate 61 was doped with oxygen ions under the condition of, for example the acceleration voltage of 400KV and the concentration of $10^{19}$ cm⁻³, to form a high concentration oxygen layer in the silicon substrate 61. Subsequently, the silicon substrate 61 was annealed at 1300°C in a nitrogen atmosphere, then the high concentration oxygen layer was oxidized to form the silicon oxide buried layer 62 in the silicon substrate 61. Thereafter, boron ions were doped under the condition of, for example the accelerataion voltage of 40KV and the concentration of $10^{15}$ cm⁻³, to make the silicon layer 63 on the buried layer 62 into p-type.

Then, as shown in Fig. 7(b), a resist film 71 with thickness of 0.4 $\mu$m was deposited on the silicon layer 63, then a portion in the resist film 71 corresponding to the channel region 68 in the silicon layer 63 was opened by a well-known patterning method.

Subsequently, as shown in Fig. 7(c), the silicon layer 63 was partly etched by the RIE method using the resist film 71 as a mask so that the thickness of a portion in the silicon layer 63 to be the channel region 68 was arranged to be, for example, 0.05 $\mu$m. Thereafter, the resist film 71 was removed.

Next, as shown in Fig. 7(d), the gate oxide film 64 was formed so that the thickness thereof became, for example, 20 $\mu$m, then a polycrystalline silicon film was deposited thereon so that the thickness of the deposited layer became 0.3 um, thereafter the gate electrode 65 was formed by a well-known patterning method. Thereafter, for example, some suitable ions are doped into the silicon layer 63 to form the source and the drain region 66, 67, further wiring is conducted by a well-known method to prepare the MOS transistor.

In the above MOS transistor obtained by the above method, the silicon layer 63 is the channel region 68 and is very thin, thus the MOS transistor is excellent in the switching characteristic. While, the silicon layer 63 in the source and the drain region (66, 67) is relatively thick, thus the increase of resistance of the diffusion regions caused by a thin SIO film and disappearance of the diffusion layers conventionally caused on forming of the contact holes can be prevented.

Incidentally, since the channel region 68 is formed by the etching method after forming the silicon layer 63, the MOS transistor can be manufactured with ease.

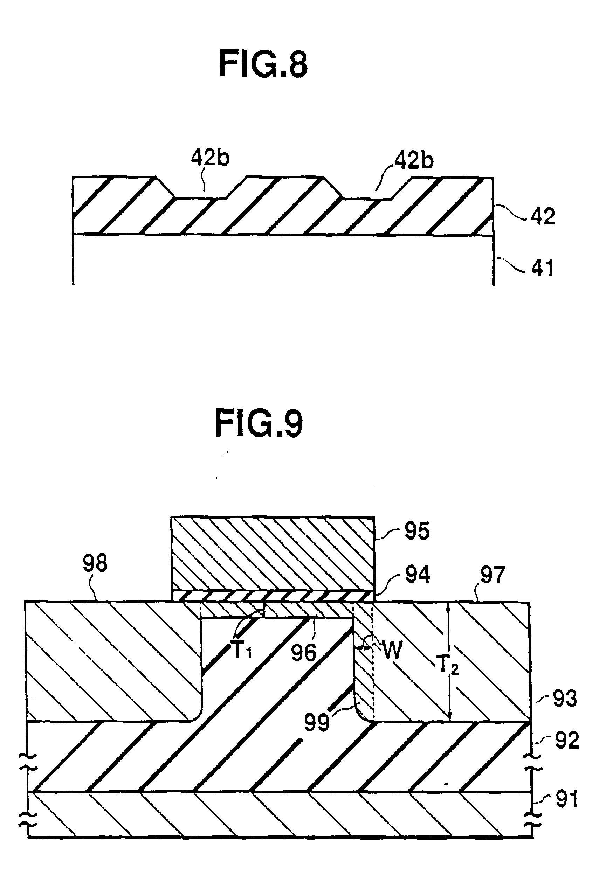

Fig. 9 is a cross sectional view to show construction of a semiconductor device of a first embodiment of the present invention.

In the drawing, on a silicon substrate 91, an insulating film 92 comprising SiO₂ film having a convex portion is formed, and an SOI film 93 comprising a p-type single-crystal silicon is formed on the insulating film 92.

On the convex portion of the insulating film 92, a gate electrode 95 is formed through a gate oxide film 94. Further, in the SOI film 93, a drain region 97 and a source region 98 are so formed as to face each other and interpose a channel region 96 under the gate electrode 95. Between the channel region 96 and the drain region 97, a region 99 is provided in contact with the drain region 97.

In a MOS-type N channel transistor having the above construction, the thickness $T_1$ of the channel region 96 is so set as to satisfy the following equation similarly to the first MOS transistor mentioned above:

$$T_1 \leq 2 \, [\epsilon \phi F/(qNsub)]^{1/2},$$

wherein $\epsilon$, $\phi$F, q and Nsub have the same meanings as those in the first MOS transistor respectively.

In the equation, the right side designates a maximum thickness in which complete depletion of the channel region 96 can be allowed in the operative mode (maximum depletion distance). Accordingly, when a thickness of the channel region 96 is in the range provided in the equation, the channel region 96 is completely depleted in the operative mode of the element. Thus, there can be obtained an excellent switching characteristic.

While, when the thickness of the drain region 97 and the source region 98 is $T_2$, $T_2$ is so set as to satisfy the following equation:

$$T_2 > T_1,$$

Namely, the drain region 97 and the source region 98 are so formed as to be thicker than the channel region 96. Thereby, concentration of the electric field in the boundary region between the channel region 96 and the drain region 97 can be mitigated as compared with the conventional construction in which the drain region is similarly thinned to the channel region. As the result, there can be elevated the drain break voltage at which the drain current is rapidly increased.

The region 99 provided between the channel region 96 and the drain region 97 has substantially the same impurity concentration as the channel region 96, and the thickness of which is substantially the same as that of the drain region 97 and the width (W) of which is so set as to satisfy the following equation:

$$O < W \leq 2 \, [\epsilon \phi F/qNsub)]^{1/2}$$

where $\epsilon$, $\phi$F, q and Nsub have the same meanings as those in the first MOS transistor respectively.

As stated above, the width(W) of the region 99 is so set as to be narrower than the maximum width in which complete depletion of the channel region 96 can be allowed in the operative mode. Namely, in the SOI film 93 of the thickness $T_2$, the boundary between the n-type high-concentration-impurity region forming the drain region 97 and the region 99 is shifted by the width of W provided by the above equation to the side of the drain region 97 from the boundary at which the thickness of the SOI film 93 changes from $T_1$ to $T_2$.

Herein, when the region 99 is not present between the channel region 96 and the drain region 97, the thick and high-concentration-impurity drain region 97 is formed directly in contact with the thin and low-concentration impurity channel region 96. In such a case, the impurity of a high concentration in the drain region 97 tends to invade the channel region 96 by heat diffusion and the like. When the impurity of the drain region 97 invades the channel region 96, since the channel region 96 is thinly formed, the impurity concentration in a portion of the channel region 96 in the vicinity of the boundary between the channel region 96 and the drain region 97 becomes high, thereby increasing change of the impurity distribution on the side of the drain region 97 in the channel region 96. Therefore, in the boundary of the channel region 96 and the drain region 97, the electric field easily concentrates, thus the drain break voltage is likely to be lowered.

However, in this embodiment, since the region 99 with a thickness substantially the same as that of the channel region 96 is provided between the channel region 96 and the drain 97, even though the impurity in the drain region 97 is diffused to the side of the channel region 96 by heat diffusion and the like, the impurity is stopped in the region 99 and does not invade the channel 96. Thus, the concentration of the electric field in the vicinity of the boundary between the channel region 96 and the drain region 97 can be mitigated, and the drain break voltage is still elevated as compared with the case that the region 99 is not present.

Incidentally, since the width of the region 99 is so set as to be narrower than the maximum width in which the complete depletion of the channel region can be allowed, the holes generated in the drain region 97 are not accumulated completely in the region 99. Therefore, change of the characteristics of the element caused by the accumulation of the holes in the region 99 having a larger thickness than the above provision does not occur.

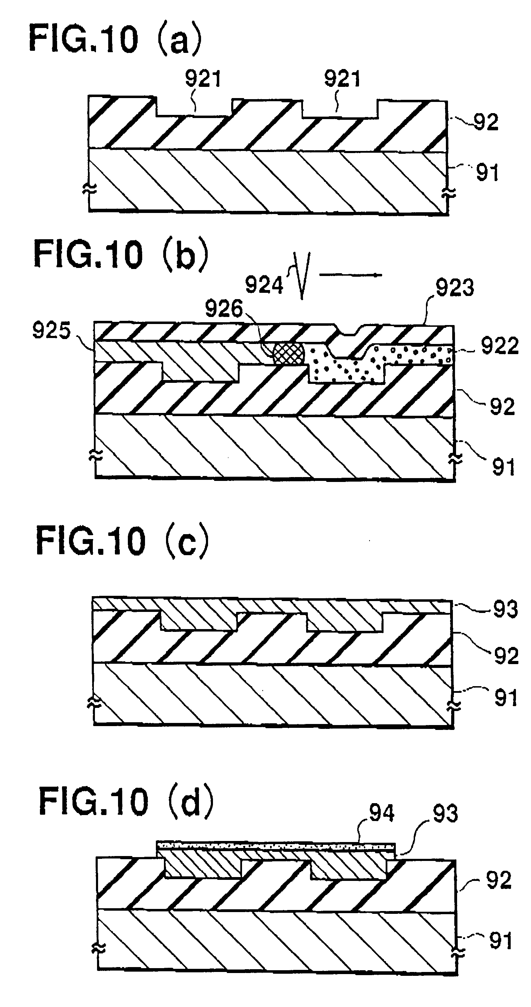

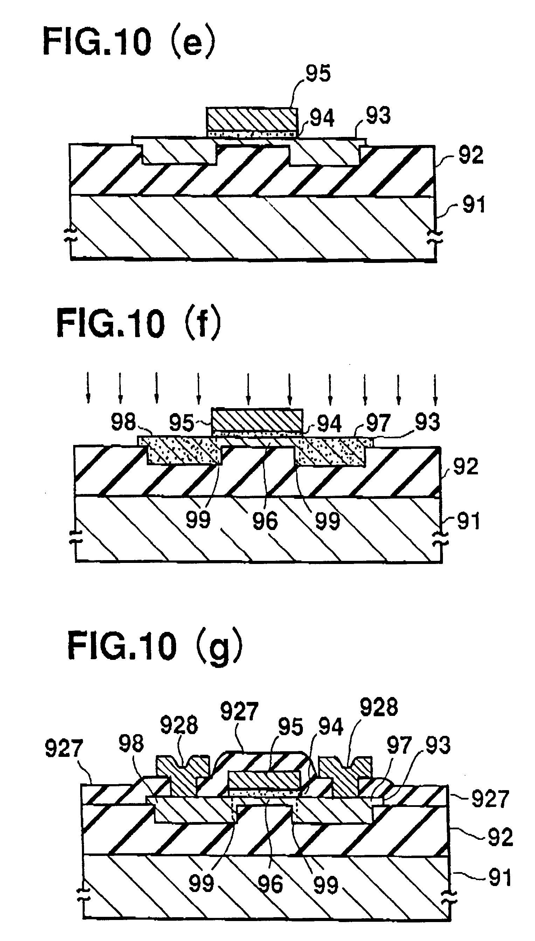

Next, a manufacturing method of a semiconductor device having the above construction will be described with reference to a manufacturing procedure shown by Figs. 10(a) to 10(g).

In the manufacturing method shown in Figs. 10(a) to 10(g), to simplify the manufacturing method, another region similar to the region 99 formed at the side of the drain region 97 is formed also at the side of the source region. 98, and the region is designated by the same reference numeral 99. In such a manner, even though the region similar to the region 99 on the side of the drain region 97 is formed on the side of the source region 98, effects of the embodiment in the present invention is not impaired, and also the characteristics thereof is not lowered.

First, the insulating film 92 comprising $SiO_2$ and having a thickness of 1.5 $\mu$m was deposited by the CVD method on the p-type single-crystal silicon substrate 91 having a surface with (100) orientation. Subsequently, a resist pattern (not shown) was formed on the insulating film 92, and concave oortions 921 with a depth of about 300 nm (3000Å) were formed using the resist pattern as a mask in the insulating film 92 by the reactive ion etching (RIE) method at a predetermined interval to each other. Thereafter, the resist pattern formed as a mask on the insulating film 92 was removed (Fig. 10(a)).

Next, polycrystalline silicon with a thickness of about 800 nm (8000 Å) was deposited on all over the surface to form a polycrystalline silicon film 922. Then, a protective film 923 comprising $SiO_2$ and having a thickness of about 500 nm (5000 Å) was formed by deposition by the CVD method on the polycrystalline silicon film 922. Thereafter, the processed substrate was subjected to the beam anneal treatment by scanning of an electron beam 924 under the condition of the acceleration energy of about 12KeV and the beam current of about 6mA, thereby conducting the melting recrystallization of the polycrystalline film 922 to form a single-crystal silicon film 925 (Fig. 10(b)). Incidentally, in Fig. 10(b), a region 926 designates a melt region of the polycrystalline silicon.

Subsequently, the protective film 923 was removed with an ammonium solution. Then, the surface of the single-crystal silicon film 925 was oxidized by the hydrogen combustion oxidization at about 1000 °C to form an oxide film (not shown). Thereafter, a p-type impurity was introduced into the single-crystal silicon 925 at a low concentration, and the oxide film formed on the single-crystal silicon film 925 was removed with an ammonium aqueous solution. Thus, the SOI film 93 comprising a p-type single-crystal silicon having thin portions on the convex portions of the insulating film 92 was formed. Herein, the thickness of a portions in the SOI film 93 to be the channel region 96 on one of the convex portions in the insulating film 92 was about 60 nm (600 Å) and the thickness of portions in the SOI film 93 to be the drain region 97 and the source region 98 on the concave portions in the insulating film 92 was about 360 nm (3600 Å) (Fig. 10 (c)).

Then, a resist pattern (not shown) was formed on the SOI film 93, the SOI film 93 except regions to be formed as an element was removed by the RIE method using the resist pattern as a mask. Thereafter, the processed substrate was subjected to the heat oxidization treatment at about 900 °C to form the gate oxide film 94 comprising $SiO_2$ with a thickness of about 20 nm (200 Å) on the SOI film. At the time, the surface of the SOI film 93 oxidized, and the thickness thereof was reduced by about 10 nm (100 Å) (Fig. 10 (d)).

Subsequently, a polycrystalline silicon film was deposited all over the surface, then a resist pattern (not shown) wider than the width of the convex portion of the insulation film 92 by 2W at most, and the polycrystalline film 93 and the gate insulating film 94 were removed by etching of the RIE method using the resist pattern as a mask. Thus, the gate electrode 95 comprising a polycrystalline silicon wider than the width of the convex portion of the insulating film 92 was formed (Fig. 10(e)).

Then, phosphorus ions as an n-type impurity was introduced to the SOI film 93 by the ion doping under the condition of the acceleration voltage of 200KeV and the dose amount of $1 \times 15^{15}$ cm$^{-2}$, thereby forming the drain region 97 and the source region 98 in the SOI film 93 so that both the regions 97, 98 interpose the gate electrode 15 therebetween. At the time, since the length (L) of the gate electrode 95 is longer than the width of the convex portion of the insulating film 92 by 2W at most as stated above, the phosphorus ions are not introduced in the SOI film 93 in the vicinity of the convex portion of the insulating film 92. According, the regions 99 having substantially the same impurity concentration as the channel region 96 formed in the SOI film 93 under the gate electrode 95 are formed between the channel region 96 and the drain and the source region 97, 98 so as to respectively have width of W at most by self-adjustment (Fig. 10(f)).

Next, and insulating film 927 was formed on all over the surface, then contact holes were formed in the drain region 97 and the source region 98. To the contact holes, aluminium wires 928 were wired, thus the MOS-type N channel transistor was formed (Fig. 10(g)).

In the so-manufactured transistor, since the drain region 97 is formed thicker than the channel region 96, the concentration of the electric field in the vicinity of the boundary between the channel region 96 and the drain region 97 can be mitigated, thereby elevating the drain break voltage. Moreover, since the region 99 of a low concentration is formed between the channel region 96 and the drain region 97, the diffusion of the impurity from the drain region 97 to the channel region 96 is prevented and the concentration of the electric field is further mitigated. Thus, the drain break voltage can be much elevated, that is, the drain voltage at which the drain current is rapidly increased as shown in Fig. 3 can be much elevated as compared with the conventional example.

Incidentally, it should be clearly understood that the present invention is not limited in the above embodiments. For example, the MOS transistor formed in the SOI film is not limited in the n channel type, but may be of the p channel type. Further, the concave portions provided in the insulating film under the single-crystal silicon layer shown in Fig. 7(c) and Fig. 10(c) may be tapered as shown in Fig. 8. Moreover, the conductive types of the channel region and the source and the drain region in Fig. 4 are not limited in n and p channels respectively, but may be the same conductive type. Additionally, the manufacturing procedures in the present invention are not limited in those shown in Figs. 2, 5, 7 and 10, but may be suitably modified in accordance with specifications. Also, others included in the construction in the present invention may be various ly modified in the range not departing from the gist of the present invention.

Further, in Fig.9 the allowable impurity concentration in the region 99 is the same or larger as compared with the impurity concentration of the channel region, and the same or smaller as compared with that of the drain region.

Reference signs in the claims are intended for better understanding and shall not limit the scope.

## Claims

1. A thin film transistor semiconductor device, comprising:

    a source region (98) and a drain region (97) each comprising a high concentration-impurity-diffusion region and provided at a predetermined interval formed on an insulating film (92);

    a gate electrode (95) formed on a channel region (96) interposed between said source region (98) and drain region (97) through a gate insulating film (94);

    a thickness (T1) of said channel region (96) being so adjusted as to be smaller than a maximum distance allowable to complete depletion of said channel region (96), and the source region (98) and the drain region (97) have a higher impurity concentration that the channel region (96).

    **characterized in that**

    the thickness of the channel region (96) is smaller than the thickness of said source region (98) and said drain region (97), and a region (99) having a width less than the maximum depletion distance and an impurity concentration substantially the same or larger than that of said channel region (96) and less than that of said drain region (97) is provided between said channel region (96) and said drain region (97) and the region (99) has substantially the same thickness as the drain region.

2. A semiconductor device according to claim 1, **characterized in that,** said insulating film (92) has a convex portion under said channel portion (96) to be formed on said insulating film (92), and concave portions respectively under said source region (98) and said drain region (97).

**Patentansprüche**

1. Dünnfilmtransistor-Halbleitervorrichtung mit: einem Sourcebereich (98) und einem Drainbereich (97), jeweils umfassend einen Diffusionsbereich hoher Verunreinigungskonzentraion und vorgesehen unter einem vorbestimmten Intervall, gebildet auf einem Isolationsfilm (92); einer Gateelektrode (95), gebildet auf einem Kanalbereich (96), zwischengesetzt zwischen dem Sourcebereich (98) und dem Drainbereich (97) über einem Gateisolationsfilm (94); wobei eine Dicke ($T_1$) des Kanalbereich (96) so eingstellt ist, daß sie kleiner ist als ein maximaler erlaubbarer Abstand zur Vervollständigung einer Verarmung des Kanalbereichs (96) und der Sourcebereich (98) und der Drainbereich (97) eine höhere Verunreinigungskonzentraion haben als der Kanalbereich (96), dadurch **gekennzeichnet**, daß die Dicke des Kanalbereichs (96) kleiner ist als die Dicke des Sourcebereichs (98) und des Drainbereichs (97), und ein Bereich (99) mit einer Breite geringer als dem maximalen Verarmungsabstand und einer Verunreinigungskonzentration im wesentlichen gleich oder größer wie der des Kanalbereichs (96) und geringer als der des Drainbereichs (97) vorgesehen ist zwischen dem Kanalbereich (96) und dem Drainbereich (97), und der Bereich (99) im wesentlichen die gleiche Dicke wie der Drainbereich hat.

2. Halbleitervorrichtung nach Anspruch 1, dadurch gekennzeichnet, daß der Isolationsfilm (92) einen konvexen Abschnitt unter dem Kanalbereich (96), welcher auf dem Isolationsfilm (92) zu bilden ist, und konkave Abschnitte jeweils unter dem Sourcebereich (98) und dem Drainbereich (97), aufweist.

**Revendications**

1. Dispositif en semi-conducteur de transistor à couche fine, comprenant :
   - une région de source (98) et une région de drain (97), chacune comportant une région de diffusion à concentration élevée en impureté et prévue à un intervalle prédéterminé, formée sur un film isolant (92);
   - une électrode de grille (95) formée sur une région de canal (96) interposée entre lesdites régions de source (98) et de drain (97) par l'intermédiaire d'un film isolant de grille (94);
   - l'épaisseur (T1) de ladite région de canal (96) étant ajustée pour être inférieure à la distance maximum permise pour un épuisement complet de ladite région de canal (96), et la région de source (98) et la région de drain (97) ont une concentration en impureté supérieure à celle de la région de canal (96),
     caractérisé en ce que :
   - l'épaisseur de la région de canal (96) est inférieure à celle de ladite région de source (98) et de ladite région de drain (97), et une région (99) ayant une largeur inférieure à la distance d'épuisement maximum et une concentration en impureté sensiblement identique ou supérieure à celle de ladite région de canal (96) et inférieure à celle de ladite région de drain (97) est fournie entre ladite région de canal (96) et ladite région de drain (97), et la région (99) a sensiblement la même épaisseur que la région de drain.

2. Dispositif en semi-conducteur selon la revendication 1, caractérisé en ce que ledit film isolant (92) comporte une portion convexe au-dessous de ladite partie de canal (96) pour être formée sur ledit film isolant (92), et des portions concaves, respectivement, au-dessous de ladite région de source (98) et de ladite région de drain (97).

# FIG.1

# FIG.2 (a)

# FIG.2 (b)

# FIG.2 (c)

# FIG.2 (d)

# FIG.3

# FIG.4

## FIG.5 (a)

42a        42a

42

41

## FIG .5 (b)

53

54        52

55        51

42

41

## FIG.5 (c)

43

42

41

## FIG.5 (d)

44

43

42

41

## FIG.5 (e)

48   45    44

57      57

46       47   43

56

42

41

# FIG.6

# FIG.7 (a)

# FIG.7 (b)

# FIG.7 (c)

# FIG.7 (d)

# FIG.8

# FIG.9

## FIG.10 (a)

## FIG.10 (b)

## FIG.10 (c)

## FIG.10 (d)

## FIG.10 (e)

## FIG.10 (f)

## FIG.10 (g)

# FIG.11

# FIG.12